Europäisches Patentamt

European Patent Office

Office européen des brevets

(11) Publication number: **0 055 409**
**A1**

(19)

# EUROPEAN PATENT APPLICATION

(12)

(21) Application number: **81110324.1**

(22) Date of filing: **11.12.81**

(51) Int. Cl.³: **G 11 C 11/40**

(30) Priority: **25.12.80 JP 184564/80**

(43) Date of publication of application:
**07.07.82 Bulletin 82/27**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Toyoda, Kazuhiro**
**39-1433, Sakuradai Midori-ku**
**Yokohama-shi Kanagawa 227(JP)**

(72) Inventor: **Sugo, Yasuhisa**
**3-25-13, Minamikoiwa**
**Edogawa-ku Tokyo 133(JP)**

(72) Inventor: **Yamada, Katuyuki**
**2063, Shimosakunobe Takatsu-ku**
**Kawasaki-shi Kanagawa 213(JP)**

(74) Representative: **Seeger, Wolfgang, Dipl.-Phys.**
**European Patent Attorney Bereiteranger 15**
**D-8000 München 90(DE)**

(54) A semiconductor memory.

(57) A semiconductor memory includes memory cells respectively provided with flip-flop circuits in which a pair of transistors are included, said flip-flop circuit being connected to a pair of bit lines $B_{00}$, $B_{01}$, ..., $B_{n0}$, $B_{n1}$) and to a pair of word lines $W_i$, $W_{ih}$). The semiconductor memory includes a pair of switching transistors connected to the pair of bit lines. One of the pair of switching transistors is turned ON while the other is OFF when they receive high and low potentials according to write data at the time of write operation so as to flow write current from a memory cell to a voltage source via one of said pair of bit lines and one of said pair of switching transistors.

EP 0 055 409 A1

./...

Fig. 4

FUJITSU LIMITED

1015 Kamikodanaka,

Nakahara-ku, Kawasaki-shi

KANAGAWA. 211, JAPAN

## A SEMICONDUCTOR MEMORY

The present invention relates to a semiconductor memory and more particularly to a bipolar memory circuit, including memory cells respectively provided with a flip-flop circuit in which a pair of transistors are included, said flip-flop circuit being connected to a pair of bit lines and a pair of word lines.

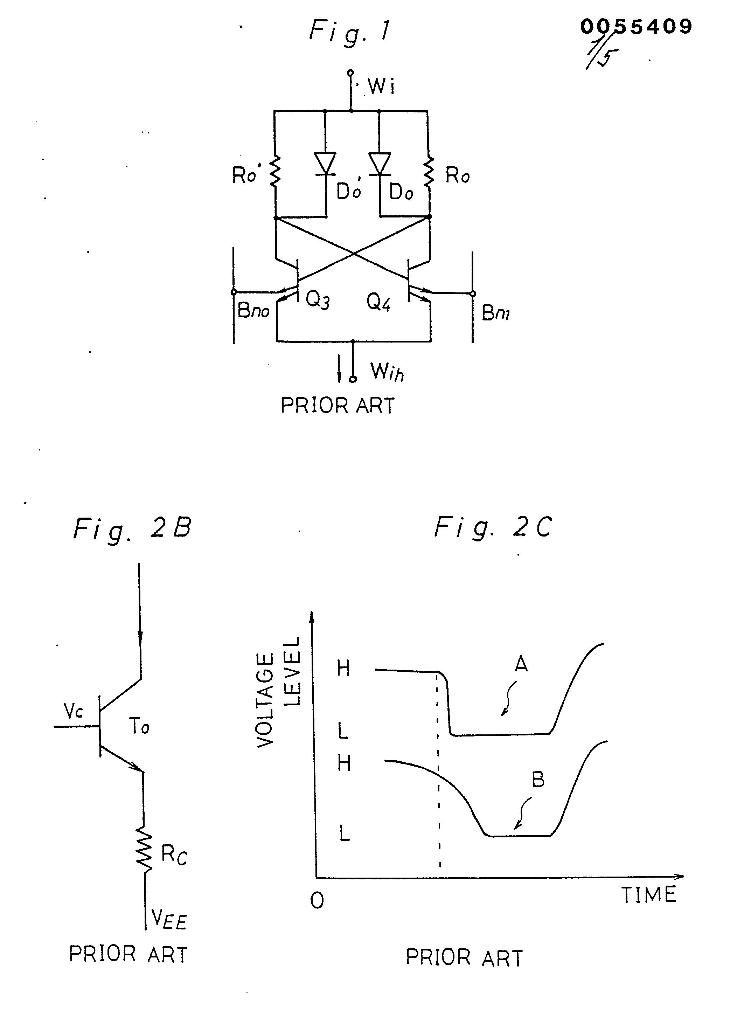

Flip-flop circuits including resistors and diodes have been employed in the memory cells of conventional semiconductor memories. Fig. 1 is a circuit diagram showing the conventional memory cell in which resistors and diodes are employed. Collectors of transistors $Q_3$ and $Q_4$ are connected to a word line $W_i$ through parallel circuits consisting of a resistor $R_0$ and a diode $D_0$, and a resistor $R_0'$ and a diode $D_0'$, respectively. First emitters of transistors $Q_3$ and $Q_4$ are connected to bit lines $B_{n0}$ and $B_{n1}$, respectively, while second emitters thereof are connected to a word line $W_{ih}$. This is a common arrangement of a flip-flop circuit. When the transistor $Q_3$ is ON,

the transistor $Q_4$ is turned OFF but when the former is OFF, the latter is turned ON. It is necessary that a certain value of voltage is applied to resistors to prevent the flip-flop circuit including resistors and diodes from carrying out malfunction or wrong read-out due to noise. It is also necessary in this case that the current flowing to the resistors in the cell is made small, or the resistance in the cell is made large to reduce power consumption in thecell or in the whole of the semiconductor memory. However, it was difficult to obtain a large resistance value in the highly-integrated memory or in the small-- sized memory cell. Because the resistor must be made long in the current-flowing direction to obtain large resistance and the resistor thus large- sized could not be provided in the small-sized memory cell.

There are now employed $I^2L$ and PNPN memory cells in which PNP transistors, for example, are used as loads instead of resistors. Transistors employed instead of resistors in the memory cell caused current saturation when they are ON, and stored charge was present in transistors, thereby to achieve anti-noise effect. This memory cell in which transistors are used instead of resistors achieves anti-noise and low power consumption effects but has a problem on the matter of high speed at the time of write operation. The stored charge must be discharged at the time of write operation and a large current must flow particularly at the time when changeover is made from 0 to 1 or from 1 to 0. The speed is therefore made high by setting the write current larger than the read-out current. When write current is set large, however, an unnecessary write time period is needed corresponding to a time period during which the write current is increased since the write operation is performed after the write current is large enough to change over to the bit lines i.e. after the write current applied to the bit lines reaches a sufficient level. This is influenced by stray capacitor or the like in current switching transistors which serve to increase current flowing through bit lines. The capacitance of the stray capacitor can be reduced by physically making transistors small-sized, but such small-sized transistors cannot serve to increase current flowing through the transistors, thereby resulting in low speed operation.

The object of the present invention is to provide a semiconductor memory capable of achieving high speed write operation in such a way that bit lines are driven by a voltage source at the time of the write operation instead of increasing the current value of a current source.

According to the invention said semiconductor memory comprises a pair of switching transistors, each of said pair of switching transistors being connected to each of said pair of bit lines, a pair of bases of said pair of switching transistors receive a pair of complementary signals according to a write data so that a write current flows from the memory cell to a voltage source via one of said pair of bit lines and one of said pair of switching transistors.

Various embodiments of methods and apparatus in accordance with this invention will now be described and contrasted with the prior art with reference to the accompanying drawing; in which:

Fig. 1    depicts a circuit diagram of a conventional memory cell,

Fig. 2A   is a circuit diagram showing the main portion of a conventional bipolar memory,

Fig. 2B   is a circuit diagram of the constant current source used in the bipolar memory,

Fig. 2C   are a voltage wave forms of the input signal and the corresponding bit line,

Fig. 3A   and 3B are circuit diagrams of other memory cells,

Fig. 4    represents a circuit diagram of one embodiment of the bipolar memory of the present invention, and

Fig. 5    shows wave forms of various signals used in the embodiment of the present invention shown in Fig. 4.

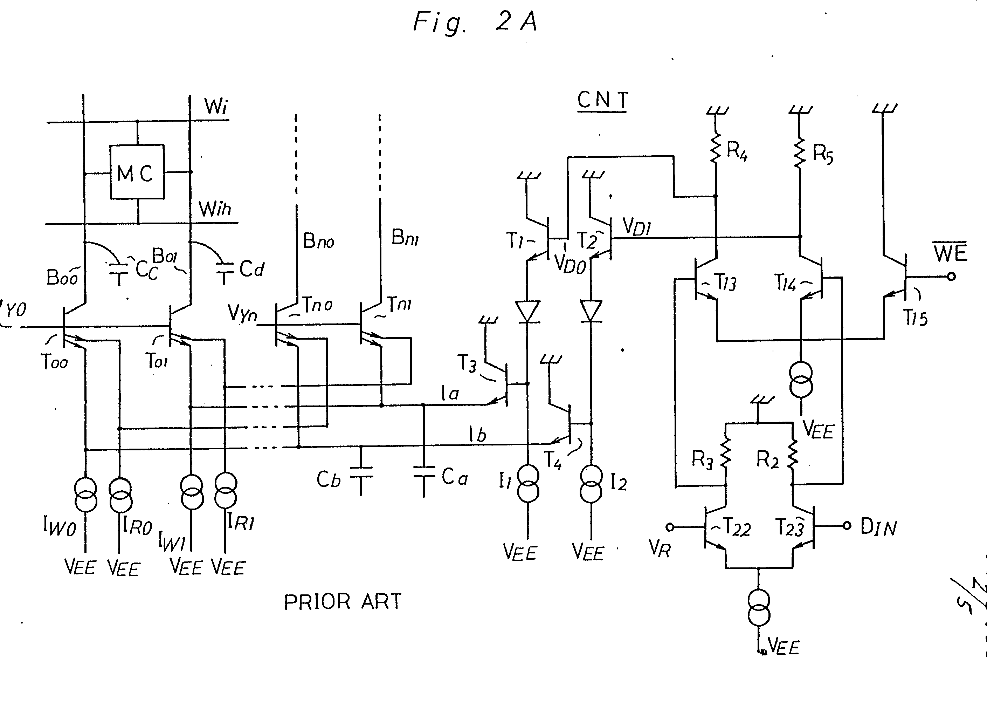

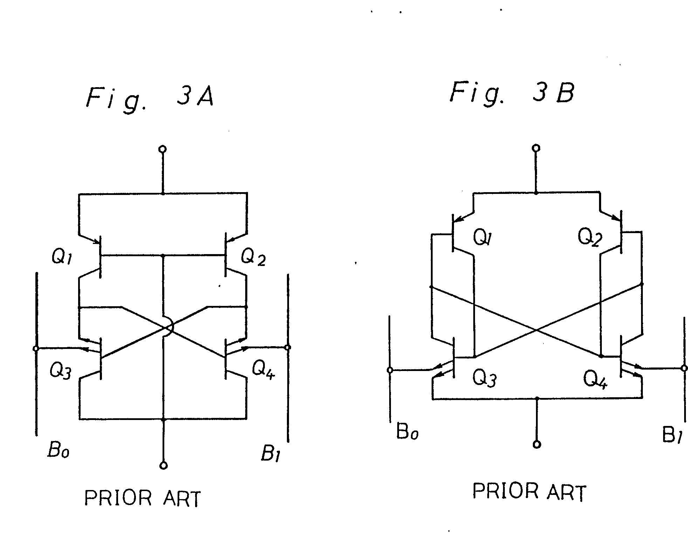

Fig. 2A shows the main portion of a prior art bipolar memory in which PNP transistors are used in loads in each memory cell. MC represents a memory cell connected to each of the points at which a pair of bit (or column) lines $B_{j0}$ and $B_{j1}$ cross a pair of word (or row) lines $W_i$ and $W_{ih}$ wherein i and j denote any of 0, 1, 2 .... and h denote a hold line. When the memory cell is of $I^2L$ type, the memory cell MC has such well-known arrangement as shown in Fig. 3A, and when it is of PNPN type, it has such well-known arrangement as shown in Fig. 3B. A flip-flop circuit is formed by transistors $Q_3$ and $Q_4$ whose bases are connected to their corresponding collectors and whose multi-emitters are connected to bit lines $B_0$ and $B_1$, respectively. This memory cell is different from the conventional one shown in Fig. 1 in that the present memory uses, as loads, transistors of conductivity opposite to that of the driver transistors instead of the resistors $R_0$ and $R_0'$ and diodes $D_0$ and $D_0'$ i.e. driver transistors $Q_3$ and $Q_4$ in this memory cell are of NPN type while load transistors $Q_1$ and $Q_2$ of PNP type.

Selecting multi-emitter transistors $T_{00}$, $T_{01}$ - $T_{n0}$, $T_{n1}$ for selecting a pair of bit lines are inserted in bit lines $B_{00}$, $B_{01}$ - $B_{n0}$, $B_{n1}$, respectively. First emitters of $T_{00}$ - $T_{n0}$ are commonly connected to a current source $I_{W0}$ and second emitters thereof to a common current source $I_{R0}$, while first emitters of $T_{01}$ - $T_{n1}$ are connected to a common current source $I_{W1}$ and second emitters thereof to a common current

source $I_{R1}$. Each pair of these transistors forms a current switch. $V_{Y0}$ - $V_{Yn}$ represent bit line selecting voltages and when one of these voltages becomes of H (or high) level, the pair of transistors to which this voltage of H level is applied are turned ON while transistors on the other pairs of bit lines are turned OFF, thus achieving bit line selection. It is assumed in this example that $V_{Y0}$ becomes of H level, transistors $T_{00}$ and $T_{01}$ are turned ON, and bit lintes $B_{00}$ and $B_{01}$ are selected. This is a condition under which write and read-out can be performed. Both write and read-out voltages $V_{D0}$ and $V_{D1}$ are in H level under read-out condition, transistors $T_1$, $T_2$, $T_3$ and $T_4$ are therefore turned ON, and current of write current sources $I_{W0}$ and $I_{W1}$ is supplied through transistors $T_3$ and $T_4$ but not from first emitters of transistors $T_{00}$ and $T_{01}$. Therefore, current of read-out current sources $I_{R0}$ and $I_{R1}$ is allowed to flow through bit lines $B_{00}$ and $B_{01}$. This read-out current serves to quickly determine potentials of bit lines $B_{00}$ and $B_{01}$ according to the storage status of memory cell. When word lines $W_i$ and $W_{ih}$, for example, are further selected, they become high in level and the memory cell MC is selected. Providing that the memory cell MC is in H level on the side of bit line $B_{00}$ and in L level on the side of bit line $B_{01}$, the bit line $B_{00}$ becomes of H level while the bit line $B_{01}$ of L level. This potential difference between these bit lines $B_{00}$ and $B_{01}$ is sensed by a sensor circuit (not shown) and read-out of storage in the memory cell MC is performed. Providing that the bit line $B_{00}$ is made of L level while the bit line $B_{01}$

is of H level just before this read-out, it is necessary that the bit line $B_{00}$ quickly rises to H level while the bit line $B_{01}$ quickly falls to L level. The rising time needed is determined by the driving capability or of memory cell MC and provides almost no problem, but it is difficult for the fall to be achieved quickly any special means of allowing discharge. Currents $I_{R0}$ and $I_{R1}$ (same symbols are here used to represent current sources and current values), particularly $I_{R1}$ in this example allows this discharge so as to cause the fall to be quickly achieved. The current source comprises an emitter follower circuit as shown in Fig. 2B, in which the emitter of a transistor $T_0$ is connected via a resistor $R_C$ to a voltage source $V_{EE}$, the base thereof receives specific voltage $V_C$, and the collector thereof corresponds to that terminal of the current source which is opposite to that on the side of power souirce $V_{EE}$.

In Fig. 2A, one of the voltages $V_{D0}$ and $V_{D1}$ is made of H level while the other is of L level or vice versa according to write information "1" and "0" at a write timing. It is now assumed that $V_{D1}$ is in L level and $V_{D0}$ is in H level, the transistor $T_4$ is turned OFF while transistors $T_1$ and $T_3$ are ON and the write current $I_{W0}$ flows through the bit line $B_{00}$. As is already well-known, therefore, current flows out from the transistor $Q_3$ in the memory cell Mc through the bit line $B_0$ (or $B_{00}$) and thus, the transistor $Q_3$ is turned OFF while the transistor $Q_4$ is turned ON, so that the storage status is inverted, to thereby perform write operation.

A write and read current controlling circuit CNT serves to input-control at the time of read and write of data wherein $R_2$, $R_3$, $R_4$ and $R_5$ denote the resistors connected to the respective collectors of transistors 23, 22, 13 and 14. The voltage level of the signal $D_{IN}$ applied to the base of the transistor $T_{23}$ is compared to that of the reference signal $V_R$ inputted to the base of transistor $T_{22}$. Only when write-enable signal $\overline{WE}$ is applied to the base of transistor $T_{15}$, the write operation is conducted. Lines $l_a$ and $l_b$ combining the write and read current controlling circuit CNT with current sources $I_{WO}$ and $I_{R1}$ have a length longer than that of the area on which all of the pairs of bit lines $B_{00}$, $B_{01}$ and $B_{n1}$ are present, and they have emitters of transistors $T_{00}$, $T_{01}$ - $T_{n0}$ and $T_{n1}$ connected thereto. Lines $l_a$ and $l_b$ have therefore large parasitic or stray capacities $C_a$ and $C_b$. Even if the transistor $T_4$ is turned OFF in this example, write current $I_{WO}$ is not immediately supplied from bit line $B_{00}$ but from the parasitic capacity $C_b$ for a little while. Namely, the charge of parasitic capacity $C_b$ is discharged just after the transistor $T_4$ is turned OFF and current is then allowed to flow from the bit line $B_{00}$ after the finish of discharge. This is shown by wave forms A and B in Fig. 2C, in which A denotes an input wave from e.g. a wave form of the power source for driving the line $l_a$, and B denotes a wave form of the bit line power source. As apparent from Fig. 2C, this results in making narrow the pulse width effective for write and short the effective write time period i.e. a long time period is needed to write. When write currents $I_{WO}$ and $I_{W1}$ are made large to improve this problem, bit line selecting transistors $T_{00}$, $T_{01}$ - and $T_{n1}$ become large- sized, making it necessary to increase the driving capacity or capability of drivers, i.e. circuits for generating voltages $V_{YO}$ - $V_{Yn}$. In addition, the bit lines also have parasitic capacities $C_c$ and $C_d$, and the rise of the signal on bit lines is made slow when a conventional current drive is employed.

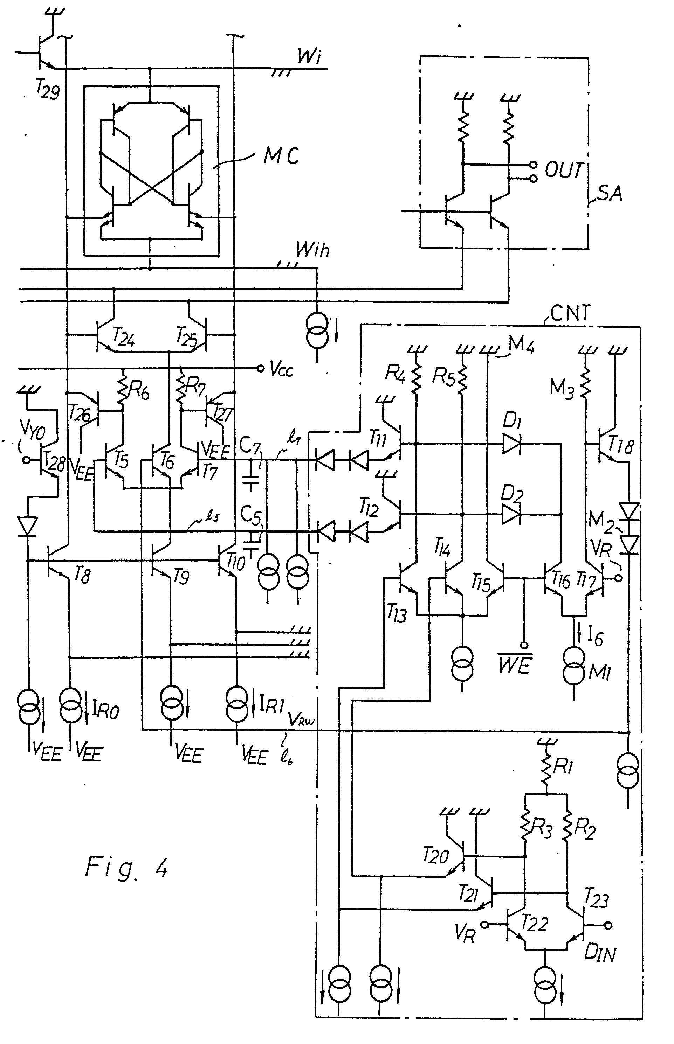

The present invention is intended to improve these matters. Fig. 4 shows an embodiment of the present invention. Similar to Fig. 2A, Fig. 4 shows only a pair of bit lines $B_{00}$, $B_{01}$, a pair of word lines $W_i$, $W_{ih}$ and a memory cell MC. However, a plurality of paired bit lines, word lines and memory cells corresponding to these paired bit lines and word lines are practically present in this embodiment. Transistors $T_8$ and $T_{10}$ serve to select bit lines and correspond to transistors $T_{00}$ and $T_{01}$ shown in Fig. 2A. Transistors $T_8$ and $T_{10}$ are of single emitter type since they handle read-out current $I_{RO}$ and $I_{R1}$ only. Write currents are supplied from transisotrs $T_{26}$ and $T_{27}$. $T_{24}$ and $T_{25}$ represent bit line potential detecting transistors, and $T_5$, $T_6$, $T_7$ and $T_9$ represent transistors for controlling these transistors $T_{24}$ and $T_{25}$. $T_{11}$ - $T_{23}$ represent transistors for controlling transistor $T_5$ - $T_7$, $T_{28}$ a transistor for selecting bit lines, and $T_{29}$ a transistor for driving word lines. $M_1$ represents a constant current source, $M_2$ a diode, $M_3$ a resistor, and $M_4$ ground.

Write enable signal $\overline{WE}$ is in H level under read-out condition. Transistors $T_{15}$ and $T_{16}$ are turned On while transistors $T_{13}$, $T_{14}$ and $T_{17}$ are turned OFF at this time and current $I_6$ flows equally to diodes $D_1$ and $D_2$. Providing that resistors $R_4$ and $R_5$ are equal in resistance value, the base potentials of both of transistors $T_{11}$ and $T_{12}$ become $-RI_6/2$ wherein R represents resistance values of $R_4$ and $R_5$, and potentials $V_{D0}$ and $V_{D1}$ of lines $1_5$ and $1_7$ become $-RI_6/2 - 2V_F$ wherein $V_F$ represents forward direction voltage of diode and is about 0.8V. Since $T_{16}$ is ON under read-out condition, the transistors $T_{17}$ is turned OFF and the base potential of transistor $T_{18}$ is about 0V. Potential $V_{RW}$ of line $1_6$ is therefore about $-2V_F$. Providing therefore that bit lintes $B_{00}$ and $B_{01}$ shown in Fig. 4 are a selected column, the transistor $T_9$ is turned ON, the transistor $T_6$ of current switches comprising transistors $T_5 - T_7$ is also turned On while transistors $T_5$ and $T_7$ are OFF, no current flows to resistors $R_6$ and $R_7$, and transistors $T_{26}$ and $T_{237}$ are turned OFF. Current flowing through the transistor $T_6$ comes to flow through bit line differential voltage detecting transistors $T_{24}$ and $T_{25}$, a transistor connected to a high potential bit line is turned ON and this is detected by a sense amplifier SA to thereby generate read-out output OUT. Output OUT has two terminals, one for positive-phase output and the other for negative-phase output.

Write enable signal $\overline{WE}$ becomes of L level under write condition, transistors $T_{15}$ and $T_{16}$ are turned OFF,

and one of the transistors $T_{13}$ and $T_{14}$ and the transistor $T_{17}$ are turned ON. Write data $D_{IN}$ is applied to the transistor $T_{23}$. Providing that data "1" and "0" correspond to H and L voltage levels, respectively, in comparison with the reference voltage $V_R$ applied to the transistor $T_{22}$, $T_{23}$ and $T_{20}$ are turned ON while $T_{22}$ and $T_{21}$ are OFF when data is "1", but $T_{23}$ and $T_{20}$ are turned OFF while $T_{22}$ and $T_{21}$ are ON when data is "0". ON and OFF of transistors $T_{13}$ and $T_{14}$ are determined by ON and OFF of transistors $T_{20}$ and $T_{21}$, and when $T_{20}$ is ON and $T_{21}$ is OFF, $T_{13}$ is turned ON and $T_{14}$ is turned OFF. When $T_{20}$ is OFF and $T_{21}$ is ON, $T_{13}$ is turned OFF and $T_{14}$ is ON. One of potentials of lines $l_5$ and $l_7$ therefore becomes H level while the other therefore becomes L level as $T_{17}$ is turned ON, base potential of $T_{18}$ becomes L level, $V_{RW}$ also becomes L level, $T_6$ of the current switches $T_5$ - $T_7$ is turned OFF, one of $T_5$ and $T_7$ is turned ON and the other thereof is turned OFF. Transistors $T_{24}$ and $T_{25}$ are thus turned OFF, rendering the lines connected to the sense amplifier SA inoperative, and one of the transistors $T_{26}$ and $T_{27}$ is turned ON to reduce the potentials of the bit lines belonging to this transistor. PNP transistors $T_{26}$ and $T_{27}$ of emitter follower connection have large driving capacity, that is, that one of the transistors $T_{26}$ and $T_{27}$ which is turned ON becomes equivalent to the situation where the corresponding bit line is connected to $V_{EE}$ and thus, it can reduce potential quickly even if parasitic capacities are present in the bit line. Further, lines $l_5$ - $l_7$ serve only to flow base current applied to transistors $T_5$ - $T_7$ but not to flow write and read currents as shown in Fig. 2A, so that operation delay caused by this portion is negligible. Furthermore, since the parasitic capacities $C_7$ and $C_5$ appearing at the respective bases of transistors $T_7$ and $T_5$ in this invention are generally smaller than the parasitic capacities $C_7$ and $C_5$ appearing at the respective emitters of transistors $T_{j0}$ and $T_{j1}$ in the prior art shown in Fig. 2B, parasitic capacities are reduced to the greater extent as compared with those in the conventional memory and this reduction of parasitic capacities serves to make operation delay of bit the lines smaller.

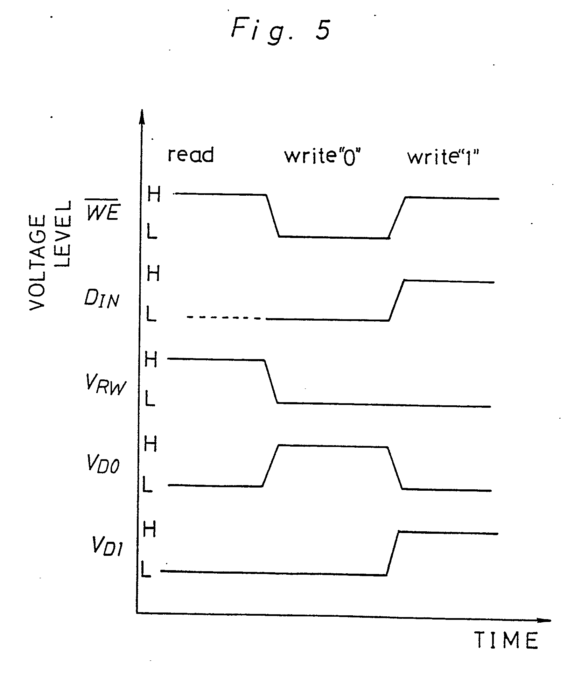

Fig. 5 is a wave-form diagram showing changes of write enable signal $\overline{WE}$, data $D_{IN}$, read control voltage $V_{RW}$ and write control voltages $V_{D0}$ and $V_{D1}$.

Since this circuit is arranged such that a write current flows from the memory cell MC to voltage source $V_{EE}$ via one of the bit lines and either of the transistors $T_{26}$ or $T_{27}$ to the bit lines and that the write and read control circuit CNT serves to control base potentials of these transistors, i.e. since the present circuit is operated under the voltage control method, write currents can be supplied at high speed to the memory cell and effective write time period can be made longer, i.e. a time period needed for writing-in. Transistors $T_{26}$ and $T_{27}$ whose collectors are connected most to the negative voltage source $V_{EE}$ are of PNP emitter-follower type and can be therefore made of vertical type (PNP semiconductor transistor combined with NPN semiconductor transistor is usually of lateral type) to easily make the gain large. In addition, bit line selecting transistors may not be large-sized multi- emitter ones as shown in Fig. 2A and, since small-sized single emitter transistors $T_8$ - $T_{10}$ serve to reduce bit line potentials at the time of read-out as described above, $T_8$ and $T_{10}$ may be omitted keeping read current sources $I_{RO}$ and $I_{R1}$ connected to bit lines. $T_9$ can be regarded as the true bit line selecting transistor from this viewpoint. Transistors $T_5$ and $T_7$ may be omitted in such a way that bases of transistors $T_{26}$ and $T_{27}$ are driven directly by potentials of lines $l_5$ and $l_7$. Transistors of the flip- flop circuit forming the memory cell are of NPN type in the embodiment of the present invention, but when they are of PNP type, the other transistors may be made inverse.

According to the present invention as described above, the write time period in the memory having a group of static memory cells in which PNP transistors are employed as loads can be made shorter and the bit line selecting transistors and their drivers can be made small-sized, simple in construction and smaller in capacity.

Claims:

1. A semiconductor memory including memory cells (MC) respectively provided with a flip-flop circuit in which a pair of transistors ($Q_1$, $Q_2$) are included, said flip-flop circuit being connected to a pair of bit lines ($B_{00}$, $B_{01}$) and a pair of word lines ($W_i$, $W_{ih}$), characterized in that said semiconductor memory comprises a pair of switching transistors, each of said pair of switching transistors being connected to each of said pair of bit lines ($B_{00}$, $B_{01}$), a pair of bases of said pair of switching transistors receive a pair of complementary signals according to a write data so that a write current flows from the memory cell (MC) to a voltage source ($V_{EE}$) via one of said pair of bit lines ($B_{00}$, $B_{01}$) and one of said pair of switching transistors.

2. A semiconductor memory according to claim 1 wherein each of said pair of switching transistors if a PNP transistor.

3. A semiconductor memory according to claim 2, wherein said semiconductor memory (MC) further comprises a pair of transistors, each collector of said pair of transistors being connected to the base of said PNP transistor and to a voltage source via a resistor, emitters of said pair of transistors being connected to each other, bases of said pair of transistors being applied with a pair of complementary potentials according to a write data.

Fig. 1

0055409

1/5

PRIOR ART

Fig. 2B

PRIOR ART

Fig. 2C

PRIOR ART

Fig. 2A

PRIOR ART

Fig. 3A

$Q_1$   $Q_2$

$Q_3$   $Q_4$

$B_0$   $B_1$

PRIOR ART

Fig. 3B

$Q_1$   $Q_2$

$Q_3$   $Q_4$

$B_0$   $B_1$

PRIOR ART

Fig. 4

Fig. 5

0055409

**European Patent Office**

**EUROPEAN SEARCH REPORT**

Application number

EP 81 11 0324

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| Y | US - A - 3 725 878 (IBM)<br>* Column 2, line 26 - column 3, line 28; figure 1 *<br><br>-- | 1 | G 11 C 11/40 |
| Y | US - A - 3 676 704 (IBM)<br>* Column 3, line 31 - column 4, line 4, the unique figure *<br><br>---- | 1,3 | |

**TECHNICAL FIELDS SEARCHED (Int.Cl. 3)**

G 11 C 11/40
7/00

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| The Hague | 23-03-1982 | DEGRAEVE |

EPO Form 1503.1 06.78